# EUROPEAN PATENT APPLICATION

(11) **EP 1 988 762 A2**
(43) Date of publication of application: **05.11.2008**
(21) Application number: 08155337.2
(22) Date of filing: 29.04.2008
(51) Int. Cl.: H05K 7/20, H02M 7/00

(54) **Phase change cooled power electronic module**

(30) Priority: 30.04.2007 US 796765
(71) Applicant: Rockwell Automation Technologies, Inc., Mayfield Heights, OH 44124 (US)
(72) Inventor: Weiss, Bruce W., Milwaukee, WI 53217 (US); Gollhardt, Neil, Fox Point, WI 53217 (US); Ahangar, Abdolmehdi Kaveh, Brown Deer, WI 53209 (US); Kannenberg, Daniel G., Waukesha, WI 53189 (US); Kaishian, Steven C., Wauwatosa, WI 53222 (US)
(74) Representative: Grünecker, Kinkeldey, Stockmair & Schwanhäusser Anwaltssozietät

(57) **Abstract**

A power electronic module is cooled by a phase change heat spreader or cooling device. The module may include switched or unswitched devices, such as power transistors, diodes, and so forth, forming circuits such as rectifiers, inverters, converters, or the like, or portions of such circuits. Heat is transferred to the heat spreader in which a continuous phase change cycle takes place to cool the circuit components. The heat spreader may extend over an area sufficient to reduce the temperature of the components, and ultimately will render portions of the overall structure more isothermal.

## Description

### BACKGROUND

The present invention relates generally to the field of power electronic devices and their thermal management. More particularly, the invention relates to a technique for improving cooling and isothermal heat distribution in power electronic modules.

Power electronic devices and modules are used in a wide range of applications. For example, in electric motor controllers, switches and diodes are employed to define rectifiers, inverters, and more generally, power converters. In a typical inverter, for example, incoming single or three-phase AC power is converted to DC power, and power electronic switches, such as insolated gate bipolar transistors (IGBTs) are switched to generate a waveform that is applied to drive a motor. Such inverter drives are particularly useful insomuch as the speed of a driven motor is a function of the frequency of the output waveform. Other similar devices, may directly convert incoming AC power to outgoing AC power, cover DC power to AC power, convert DC power to outgoing DC power, and so forth. Other power electronic devices incorporated in such circuits may include silicon controlled rectifiers (SCRs), and other devices.

Depending upon the size and rating of the circuits and components used in power electronic circuits, a plurality of components are typically disposed on a common support or substrate to form a module. The module may, itself and by the interconnection of the associated components, form a rectifier, a portion of a rectifier, an inverter, one leg of an inverter, a collected set of switches for an inverter, or similar subsystems for converters. A continuing issue in such devices is the management of heat that is generated by conduction and switching of the power electronic components. In general, internal conduction and switching losses will generate heat during operation which must be channeled from the components and limited to protect the components from damage and to extend their useful life. This is typically done by associating a substrate or module on which the components are disposed with some sort of heat sink. Monolithic, finned, and other heat sinks are typically bonded or soldered to the substrate and serve to draw heat away from the components, spread heat to some limited extend, and transfer heat to the environment.

While such structures do function to reduce the heat generated by power electronic components, increasing power density of devices, and increased power ratings have extended these techniques to their physical limits. That is, pure monolithic heat spreaders and heat sinks simply cannot establish temperature gradients necessary for further reducing component temperatures or rendering substrates and power electronic modules more isothermal. As a result, temperatures adjacent to or in the region of the power electronic components generating heat tend to remain at a substantially higher temperature than the remainder of the substrate, eventually limiting the useful life of the components and of the overall system. These limits, for a practical standpoint, limit the power rating of the overall system and the potential power density.

There is a need, therefore, for improved techniques for reducing temperature of power electronic modules and for rendering such modules and their substrates more isothermal.

### BRIEF DESCRIPTION

The invention provides a novel approach to power electronic module thermal management designed to respond to such needs. The technique may be applied in a wide range of settings, but is particularly well-suited to power converters, inverters, and similar circuits. The technique may be utilized with AC or DC power, or both, as well as with single phase and three-phase systems. A presently contemplated implementation, for example, is with complete inverter modules or partial inverter modules used for motor drives.

The technique relies upon a phase change cooled device that can be closely associated with or even incorporated into a substrate or support structure of a power electronic module. The phase change device itself utilizes evaporation and condensation to transfer heat from one plate-like side to another plate-like side, the first plate structure forming an evaporator, and the second plate structure forming a condenser. A continuous phase change cycle takes place in the device to continuously extract heat from the power electronic module. The phase change cooling device extends over a surface of the power electronic module to be cooled, and by operation of the phase change both extracts heat and significantly reduces temperature differences within regions of the power electronic module base, rendering the overall system more isothermal.

### DRAWINGS

These and other features, aspects, and advantages of the present invention will become better understood when the following detailed description is read with reference to the accompanying drawings in which like characters represent like parts throughout the drawings, wherein:

FIG. 1 is a diagrammatical overview of an exemplary power electronic circuit implementing phase change heat spreaders or cooling devices in accordance with aspects of the invention;

FIG. 2 is a diagrammatical view of an alternative configuration of a power electronic circuit utilizing separate circuit modules;

FIG. 3 is diagrammatical representation of further exemplary power electronic device utilizing multiple dedicated power electronic modules;

FIG. 4 is a diagrammatical view of a power electronic switch module for use in a power converter or inverter;

FIG. 5 is a diagrammatical side view of power electronic device employing an integrated phase change cooling device in accordance with the invention;

FIG. 6 is a plan view of a portion of a module of the type shown in FIG. 5 showing placement of exemplary components in the module;

FIG. 7 is a diagrammatical side view of a further power electronic module utilizing a phase change cooling device;

FIG. 8 is a top plan view of the device of FIG. 7;

FIG. 9 is a sectional view through an exemplary phase change cooling device or heat spreader for use in any one of the applications envisaged by the invention;

FIG. 10 is a top view of a series of conductors used in power electronics applications associated with phase change cooling or heat spreading devices;

FIG. 11 is sectional view through one of the conductors and phase change heat spreaders of the arrangement illustrated in FIG. 10;

FIG. 12 is a partial sectional view through an exemplary arrangement for cooling power busses in accordance with aspects of the invention;

FIG. 13 is a similar sectional view illustrating an integrated phase change cooling device with power busses;

FIG. 14 is a sectional view through another exemplary arrangement for cooling conductors or busses for power electronics applications;

FIG. 15 is an elevational view of an exemplary connection cooling arrangement for power electronic systems; and

FIG. 16 is a similar side elevation of an integrated phase change cooling device used for cooling connections in power electronic circuitry.

### DETAILED DESCRIPTION

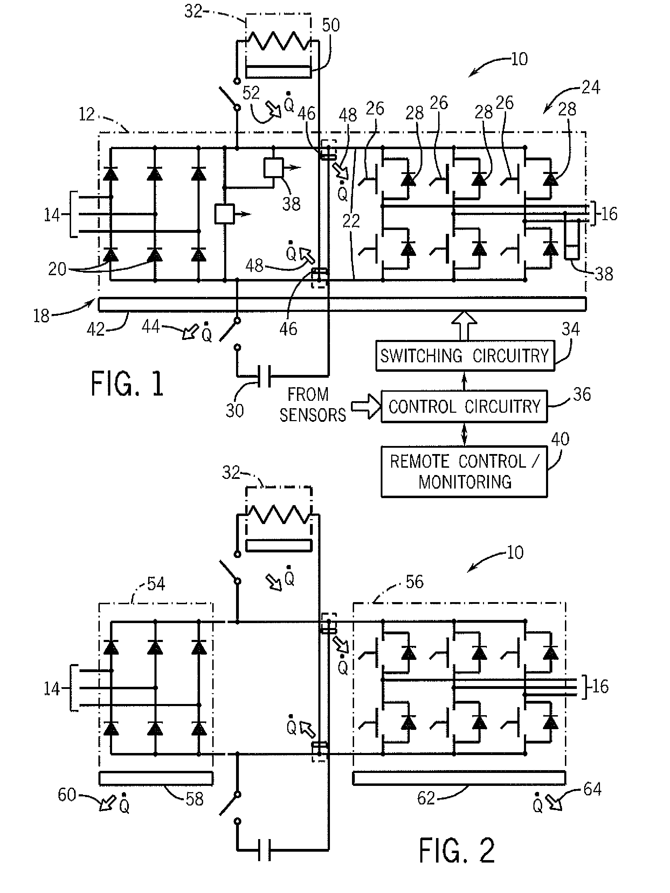

Turning now to the drawings, and referring first to FIG. 1, an exemplary power electronic circuit 10 is illustrated in which phase change heat spreaders or cooling devices are employed in accordance with aspects of the invention. In the illustrated embodiment, circuit 10 forms a power module 12, such as for a motor drive. The power module is adapted to receive three-phase power from a line side 14 and to convert the fixed frequency input power to control frequency output power delivered at a load side 16. While an inverter circuit will generally be described below as an example of an application of the present invention, it should be borne in mind throughout this discussion that the invention is not limited to this or any particular power electronic circuit. Indeed, the invention may be used in inverter applications, converter applications, AC-to-AC circuitry, AC-to-DC circuitry, DC-to-AC circuitry, and DC-to-DC circuitry. Certain of the inventive aspects may be applied in a wide range of power electronics applications, particularly where hot spots or non-isothermal conditions exist in components, in modules, in substrates, and so forth.

In the embodiment illustrated in FIG. 1, module 12 includes a rectifier 18 defined by a series of diodes 20. The diode array converts three-phase input power to DC power that is applied to a DC bus 22. An inverter circuit 24 is formed by an array of switches 26 and associated fly-back diodes 28. As will be appreciated by those skilled in the art, the switches may include any suitable power electronic devices, such as insulated gate bipolar transistors.

A range of other components may be included in the circuitry illustrated in FIG. 1. For example, a capacitive circuit 30 may be coupled across the DC bus and may be switched in and out of the circuit as needed. Similarly, the circuitry may include a choke (not shown) that may be selectively coupled across the bus. In certain arrangements, such capacitive circuitry may be permanently connected across the DC bus. Also, in the illustrated embodiment, a brake resistor module 32 is provided that may be switched in and out of connection across the DC bus, such as to dissipate energy during braking of an initial load, such as an electric motor.

Circuitry such as that illustrated in FIG. 1 will generally be associated with switching circuitry 34 which will provide the necessary control signals for the switches 26 of the inverter. Where other system topologies are provided, similar switching circuitry will typically control solid state switching components, such as silicon controlled rectifiers, and so forth. Control circuitry 36 provides control signals for regulating operation of the switching circuitry in accordance with pre-defined drive protocols. The switching circuitry 36 will typically receive feedback signals from a range of sensors 38, such as for sensing currents, voltages (e.g., at the DC bus, of incoming power, outgoing power, and so forth), speeds of a driven load, and so forth. Finally, remote control-monitoring circuitry 40 may be included that may be coupled to the control circuitry 36, such as via a network connection. This circuitry may allow for remote configuration, control, monitoring and the like of the power electronic circuitry, such as for coordinating operation of the load in conjunction with other loads. Such arrangements are typically found in more complex automation systems, such as for factory automation.

Certain locations, components, modules or subsystems of the power electronic circuitry 10 may make use of a phase change heat spreader or cooling device in accordance with aspects of the invention. In general, such devices may be employed to improve heat transfer from heat sources, such as switched components, un-switched components, busses and conductors, connection points, and any other source of heat. As will be appreciated by those skilled in the art, during operation many of the components of such circuitry may produce heat generally by conduction losses in the component, or between components. Such heat will generally form hot spots, which may be thought of as regions of high thermal gradient. Conventional approaches to extracting heat to reduce the temperature of such sources include extracting heat by conduction in copper or other conductive elements, circulation of air or other fluids, such a water, and so forth. The present approach makes use of phase change devices that not only improve the extraction of heat from such sources, but aid in distributing the heat to render the heat sources and neighboring areas of the circuitry more isothermal.

In the embodiment illustrated in FIG. 1, for example, an overall module cooling device 42 is illustrated diagrammatically. This cooling device may spread heat over the entire surface area of the power module 12. The heat, or heat flow, as indicated by the letter 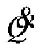 in the drawings, and by the arrow 44 in the case of cooling device 42, will be removed by operation of the cooling device so as to cool the module and to reduce temperature gradients in the components and in the module itself. That is, the cooling device promotes a more isothermal distribution of temperatures, evening heating and allowing more heat to be extracted by virtue of such temperature distribution. Details for exemplary construction of the phase change cooling device are provided below. Other locations of similar cooling devices may include at or adjacent to busses or connections, as indicated by reference numeral 46 in FIG. 1, to enhance the heat flow 48 from such locations, and to render these locations more isothermal with surrounding structures. Also illustrated in FIG. 1, separate components, such as braking resistor module 32 may also be associated with similar cooling devices 50 so as to enhance heat flow from these separate devices as indicated by reference numeral 52.

In certain circuit configurations, the components illustrated in FIG. 1, and indeed other components depending upon the nature of the power electronic circuitry, may be associated in the plurality of modules that may be separately cooled by means of phase change heat spreaders or cooling devices in accordance with the invention. FIG. 2 illustrates, for example, a power electronic circuit essentially similar to that of FIG. 1, but rated for higher power. In this embodiment, a rectifier module 54 is configured separately from an inverter module 56. While the modules may include similar components to those described above with reference to FIG. 1, the packaging of these components and separate modules may be useful for limiting the overall size of the individual modules, aiding in heat transfer from the modules, and so forth. The present invention may be applied in such applications by associating a separate cooling device with each of these modules. For example, in FIG. 2, a first cooling device 58 is illustrated for the rectifier module 54 to enhance heat transfer from this module, as indicated by reference numeral 60. Another, separate cooling device 62 is associated with the inverter module 56 to assist in heat transfer from this module as indicated by reference numeral 64. As will be appreciated by those skilled in the art, the benefits of heat extraction and isothermal heat distribution are nevertheless attained because hot sports adjacent to heat sources in each of these modules are cooled by improved and more isothermal heat distribution with surrounding structures of each module.

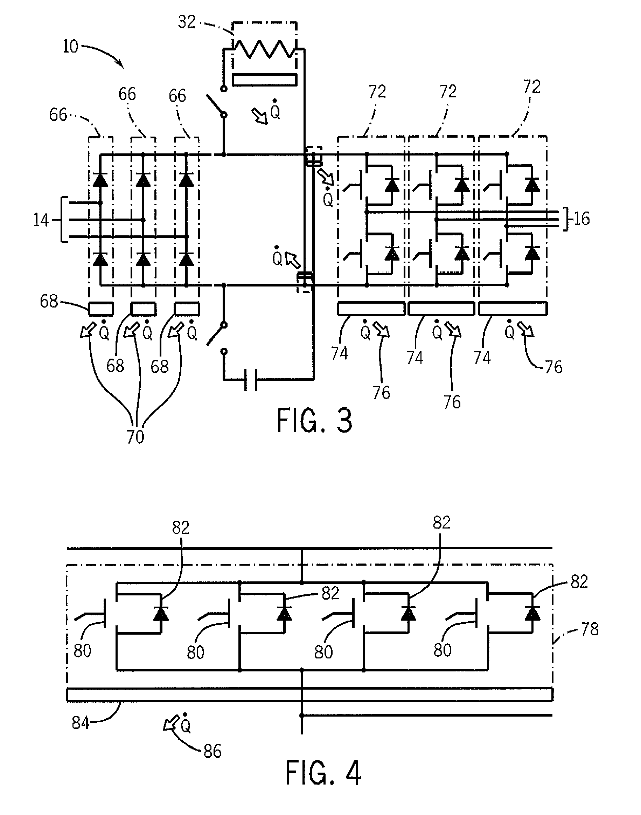

Still further, in larger systems the same circuitry may be packaged in multiple separate modules as illustrated generally in FIG. 3. In this arrangement, for example, the rectifier circuitry is defined by separate rectifier legs 66 which are separately packaged and associated with their own individual phase change heat spreaders or cooling devices 68 for promoting heat transfer from each of these as indicated generally by reference numeral 70. Similarly, separate inverter legs 72 are separately packaged and each is associated with its own cooling device 74 for promoting heat transfer from the individual package as indicated by reference numeral 76. These packaging considerations, again, may be dictated by the size, design, rating, and so forth of the individual components and the overall power electronic circuitry.

FIG. 4 illustrates another exemplary power electronic module in the form of four parallel switches with associated fly-back diodes. The module 78 may be considered a switching module that may be used in a larger or higher rated inverter of the type illustrated in the previous figures. These switches 80 are arranged in parallel and fly-back diodes 82 are provided around each switch. In certain applications, it may be useful to provide a package of switches of this type to allow for higher currents and therefore power ratings for the overall power electronic circuitry. As in the previous examples, the module 78 is associated with a phase change heat spreader or cooling device 84 which aids in extraction of heat during operation of these switches and diodes, and renders the overall module more isothermal. The heat extraction, as indicated generally by reference numeral 86, is provided for the overall module in this design, as in the previous examples.

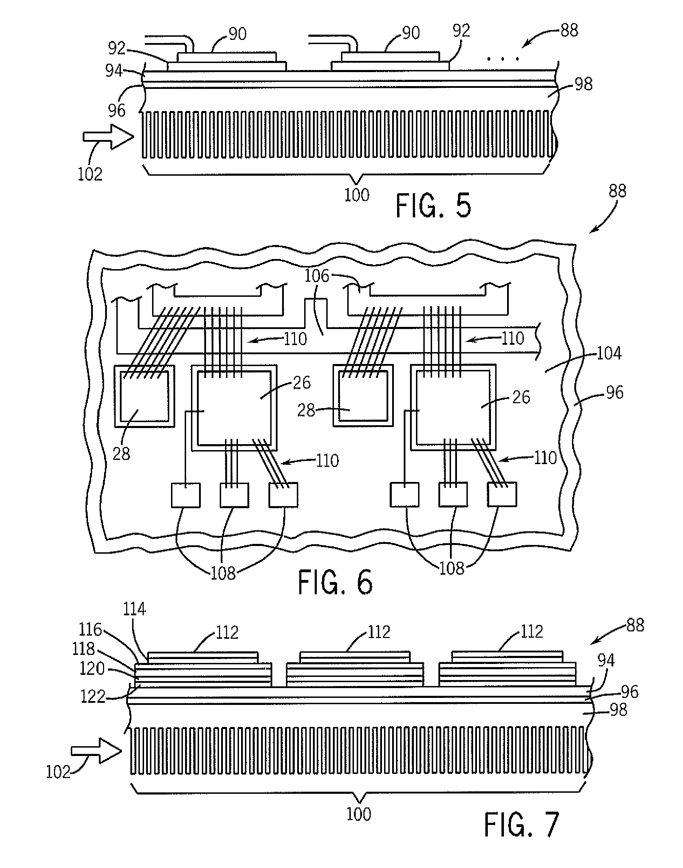

The power electronic circuits that are cooled in accordance with techniques provided by the invention may take on a wide range of physical forms. For example, power electronic switches may be provided in lead frame packages or may be stacked on assembled modules of the type illustrated in FIGS. 6-8. Moreover, when provided as a cooling mechanism for a power module or other power electronic circuitry, the cooling devices may be integrated directly into the modular circuitry or added to the modular circuitry after assembly. FIG. 5, for example, illustrates an exemplary configuration wherein a cooling device is integrated directed into the assembly itself. FIG. 5 illustrates a portion 88 of a power electronic module on which power electronic switches 90 are disposed. The switches are mounted directly on additional component circuitry such as a direct bond copper layer 92 by means of a bonding technique. In the illustrated embodiment, the phase change cooling device or heat spreader 94 serves as the substrate or base for the switches. A thermal bond or thermal grease 96 is provided between the cooling device and a heat sink 98. Heat is extracted from the switching devices during operation by the cooling device 94, and is distributed more evenly at the cooling device level, allowing the heat sink 98 to extract heat more evenly and thereby extract more heat from the assembly. Further thermal management structures may be provided, such as fins 100 over which an air flow 102 may be directed. Other arrangements may include various known fin or heat dissipating structures, liquid cooling arrangements, and so forth.

FIG. 6 illustrates an exemplary top view of the portion 88 of the power electronic module shown in FIG. 5. The switches may, in the illustrated embodiment, correspond to the power electronic switches 26 shown in the preceding figures (*see, e.g.,* FIG. 1) along with diodes 28. These components are generally laid out on a base or substrate 104 (e.g., direct bond copper) along which conductive traces 106 are formed for conducting current between the components and to and from the components and external circuitry (not shown). Terminal pads 108 may be provided on the substrate or on other supports or components associated with illustrated substrate. Wire bond connections 110 are typically made by welding or soldering conductive wire to the devices and to terminal pads to provide for the flow of current between the components and between the components and external circuitry. In the illustrated embodiment, the entire module may be cooled by the cooling device shown in FIG. 5, with the layer 96 being visible below the circuit board in FIG. 6. As noted above, where separate modules are provided for separate portions of the power electronic circuitry, physically separate phase change heat spreaders or cooling devices may be provided.

FIG. 7 illustrates a further exemplary embodiment in which a phase change cooling device is added to a preassembled power electronic module. The module 88 illustrated in FIG. 7 includes a series of power electronic devices or chips 112 that are disposed via a solder connection 114 on an underlying direct bond copper substrate, including a conductive (copper) layer 116 on a ceramic layer 118. The ceramic layer 118, then, has a further conductive (copper) layer 120 bonded to it. A further solder layer 122 thermally couples the stack to the phase change heat spreader or cooling device 94 described above. Here again, this device may, in turn, be mounted on a heat sink 98 by means of a thermal bond or grease layer 96.

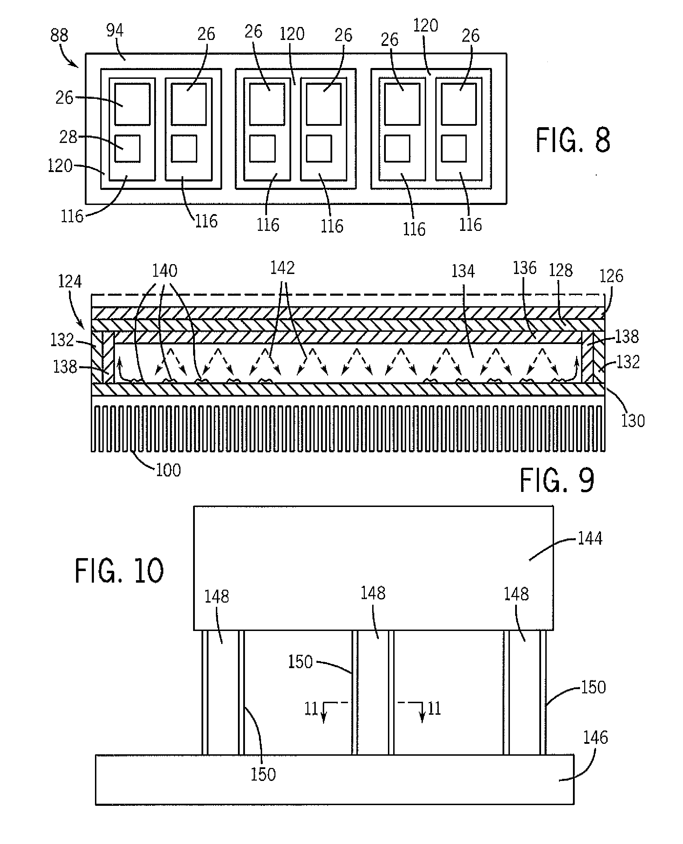

An exemplary top view of an arrangement of this type is shown in FIG. 8. Here again, the cooling device 94 may be seen below the ceramic layers 120 on which the copper layers 116 and, eventually, the power electronics circuits in the prepackaged chips are positioned. The chips in the embodiment illustrated in FIG. 8, are designed to include the switches 26 and diodes 28 described above (*see, e.g.,* FIG. 1).

It should be noted that, when used to cool any one of the power modules described above, or any other module, the phase change heat spreader may be an integral support or may be thermally coupled to a support. In general, the term "support" may include a mechanical and/or electrical layer or multiple layers or even multiple devices on which the circuitry to be cooled is mounted, formed or packaged.

As noted above, the phase change heat spreader or cooling device associated with a full or partial power electronic module enables heat to be extracted from hot spots in the module and distributed more evenly over the module surface. The modules thus associated with phase change heat spreaders have been found to operate at substantially lower temperatures, with temperatures of hot spots being particularly lowered by virtue of the distribution of heat to a greater surface area owing to the action of the phase change heat spreader.

An exemplary phase change heat spreader is illustrated in section in FIG. 9. As shown in FIG. 9, an exemplary cooling device 124 suitable for use in the embodiments of the invention will typically be positioned immediately adjacent to a hot substrate or device layer 126, The substrate 126 is to be cooled. Ultimately, as described below, the underlying structures reduce thermal gradients and more evenly distribute heat for improved heat extraction. The cooling device 124, itself, is formed of an evaporator plate 128 disposed in facing relation and space from a condenser plate 130. Sides 132 extend between the plates to hold the plates in a fixed mutual relation and to sealingly close an internal volume 134. A primary wick structure 136 is disposed immediately adjacent to the evaporator plate 128, and secondary wick structures 138 extend between the condenser plate 130 and the primary wick structure. It should be noted that another section of the secondary wick structure (not shown in the figures) may extend over all or a portion of the condenser plate.

The various materials of construction for a suitable phase change cooling device may vary by application, but will generally include materials that exhibit excellent thermal transfer properties, such as copper and its alloys. The wick structures may be formed of a similar material, and provide spaces, interstices or sufficient porosity to permit condensate to be drawn through the wick structures and brought into proximity of the evaporator plate. Presently contemplated materials include metal meshes, sintered metals, such as copper, and so forth. In operation, a cooling fluid, such as water, is sealingly contained in the inner volume 134 of the device and the partial pressure reigning in the internal volume allows for evaporation of the cooling fluid from the primary wick structure due to heating of the evaporator plate. Vapor released by the resulting phase change will condense on the secondary wick structure and the condenser plate, resulting in significant release of heat to the condenser plate. To complete the cycle, the condensate, indicated generally by reference numeral 140 in FIG. 9, will eventually reach the secondary wick structures through which it will be transferred to the primary wick structure to be re-vaporized as indicated by reference numeral 142. A continuous thermal cycle of evaporation and condensation is thus developed to effectively cool the evaporator plate and transfer heat to the condenser plate. Because the evaporator plate extends over areas of hot spots, and beyond the hot spots to adjacent areas, and because evaporation takes place over this extended area by virtue of the primary wick structure, heat is more evenly distributed over the surface area of the condenser plate, and hence the hot substrate 126, than in conventional heat sink structures.

It should be noted that, as mentioned above, and in further embodiments described below, the phase change heat spreader may be designed as an "add-on" device, or may be integrated into the design of one of the components (typically as a support or substrate). Similarly, the fins on the various structures described herein may be integral to the heat spreader, such as with the condenser plate. Also, the cooling media used within the heat spreader may include various suitable fluids, and water-based fluids are one example only. Finally, the ultimate heat removal, such as via the fins or other heat dissipating structures, may be to gasses, liquids, or both, through natural of forced convection, or a combination of such heat transfer modes. More generally, the fins described herein represent one form of heat dissipation structure, while others may be used instead or in conjunction with such fins.

The phase change heat spreader or cooling device of FIG. 9 may be used in any one or all of the settings contemplated by the present discussion. That is, such as device may extend over all or a portion of a power module or, more generally, any power electronic circuitry. Devices of this type may be used for specific cooling locations, such as conductors and busses as described below. Similarly, locations such as attachment points for wire bond conductors, at which point heat may be generated due to resistive losses, may also benefit from individual, even relatively small phase change heat spreaders. Moreover, as discussed below, specific components may be associated with individual phase change heat spreaders or cooling devices, such as brake resistors, and so forth.

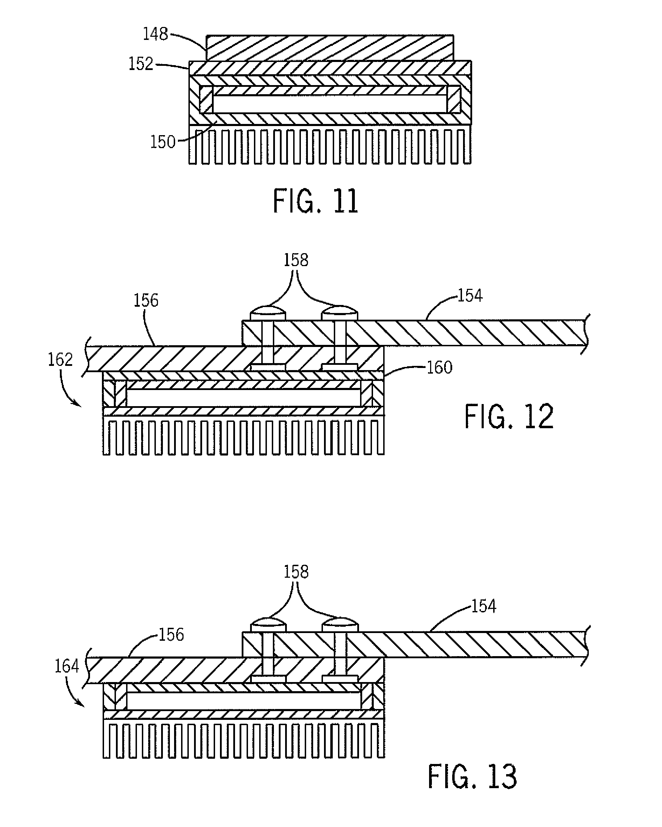

FIGS. 10 and 11 illustrate an exemplary utilization of a phase change heat spreader or cooling device for cooling conductors extending between a power electronic circuit module and a terminal element. In the illustrated embodiment, a power electronic circuit board 144 is electrically coupled to a terminal 146 by means of a series of conductors 148. Such conductors may be strips of conductive metal, braids, or traces formed on the same or a separate board. Moreover, such conductors may provide parallel connections between the board and the terminal or may channel separate phases of electrical power between the board and terminal. In the illustrated embodiment, a cooling device 150 is associated with each of the conductors 148 to extract heat from the conductor resulting from resistive losses. As illustrated in FIG. 11, the conductor itself may be separated from the cooling device 150 by means of a dielectric layer or material 152 (see FIG. 11). Suitable dielectric materials may include polyamide films, sheets, and so forth. Where such separation is not required, that is, where the cooling device may be placed at the same potential as the conductor itself, such dielectric or insulating layers may be eliminated.

Other locations where the phase change heat spreaders may be employed for cooling bus structures are illustrated in FIGS. 12-14. As shown in FIG. 12, a bus member 154 is often joined to additional bus members, as indicated by reference numeral 156. Such joints, as will be appreciated by those skilled in the art, may be made by means of fasteners 158, or other securing structures, such as clamps, solder or welded joints, and so forth. Because such joints, and indeed the overall bus structures, may experience heating during operation, a phase change heat spreader may be employed, which may be separated from the bus structure by a suitable dielectric or insulating layer 160. The cooling device itself, indicated generally by reference numeral 162 in FIG. 12, may be formed as described above with reference to FIG. 9. The area over which the heat spreader extends may be substantially greater than the individual hot spot anticipated at the bus junction point, thereby enabling the device to extract additional heat and spread heat over a larger surface, rendering the structure more isothermal.

FIG. 13 illustrates a similar arrangement, but wherein the cooling device 164 is integrated into the bus structure itself. That is, a primary wick structure is secured immediately adjacent to a lower phase of the bus member 156, and the remaining components of the cooling device are directly associated with the bus member 156. The arrangement of FIG. 13 may be similar to arrangement in which the cooling devices are integrated directly as a substrate or base of a power electronics module.

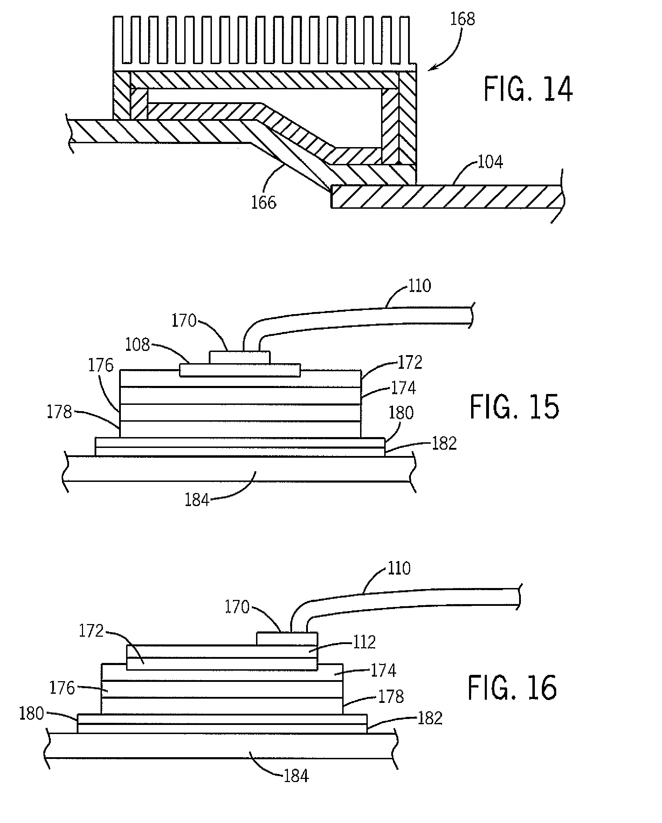

FIG. 14 illustrates an exemplary utilization of a phase change heat spreader or cooling device in a bus or conductor 166 that is secured directly to a power electronic module or circuit board 104. In the embodiment illustrated in FIG. 14, the primary wick structure may be directly associated with the bus member 156 so as to draw heat from the conductor during operation. The other components of the phase change heat spreader, then, may be contoured to follow the layout of the conductor 166 as indicated generally by reference numeral 168 in FIG. 14.

As noted above, such phase change heat spreaders or cooling devices may also be associated with individual points, even relatively small points in the power electronic devices to extract heat from these during operation. FIGS. 15 and 16 illustrate the incorporation of such a phase change device to withdraw heat from a connection point, in this case the point of connection of a wire bond conductor. The conductor 110 will typically be bonded to a conductive pad 108 by means of a solder connection or weld 170. In the illustrated embodiment, a dielectric layer 172 is then provided that is bonded to a phase change cooling device 176 by means of a thermal and mechanical bond layer 174, such as solder. The cooling device 176, then, is mounted on a dielectric layer 178 which separates it from a thermally conductive layer, such as a copper layer 180. A thermal bond layer 182, such as thermal grease, may then serve to bond the conductive layer 180 to a heat sink or other thermal management structure 184. The resulting arrangement allows for heat to be extracted from the wire bond connection, distributed more evenly over a greater surface area by virtue of the phase change that occurs in the cooling device 176, and then to transfer this heat to thermally downstream components such as the heat sink 184.

FIG. 16 illustrates a similar arrangement, but wherein the wire bond connection is made directly to a power electronic device or chip 112. As noted above, such connections will typically be made to a lead or conductive pad on the power electronic device package or chip. The underlying structure may be essentially identical to that described above with reference to FIG. 15. That is, the chip 112 is mounted on a dielectric layer 172, which is, itself, mounted on a cooling device 176 by means of a bond layer 174. The heat extracted by the cooling device 176 is transmitted to a conductive layer 180 by means of a dielectric layer 176, and therefrom through a thermal bond layer 182 to a heat sink 184.

While only certain features of the invention have been illustrated and described herein, many modifications and changes will occur to those skilled in the art. It is, therefore, to be understood that the appended claims are intended to cover all such modifications and changes as fall within the true spirit of the invention.
In summary of the invention a power electronic module is cooled by a phase change heat spreader or cooling device. The module may include switched or unswitched devices, such as power transistors, diodes, and so forth, forming circuits such as rectifiers, inverters, converters, or the like, or portions of such circuits. Heat is transferred to the heat spreader in which a continuous phase change cycle takes place to cool the circuit components. The heat spreader may extend over an area sufficient to reduce the temperature of the components, and ultimately will render portions of the overall structure more isothermal.

## Claims

1. An electronic power module comprising:
a plurality of power electronic devices mounted to a first side of a support; and
a phase change heat spreader adjacent to a second side of the support opposite the first side and configured to draw heat from the devices during operation.

2. The electronic power module of claim 1, wherein the power electronic devices include a plurality of diodes.

3. The electronic power module of claim 2, wherein diodes are interconnected to form a rectifier.

4. The electronic power module of claim 1, 2 or 3 wherein the power electronic devices include a plurality of solid state switches.

5. The electronic power module of claim 4, wherein the solid state switches are interconnected to form a power converter.

6. The electronic power module of claim 5, wherein the power converter is a three phase inverter.

7. The electronic power module of claim 1, wherein the power electronic devices include a plurality of solid state switches and diodes interconnected to form a rectifier and three phase inverter.

8. The electronic power module of one of claims 1 to 7, wherein the phase change heat spreader includes an evaporator side adjacent to the second side of the support, a wick structure for channeling condensate to the evaporator side, a condenser side opposite the evaporator side, and a cooling medium sealed between the evaporator side and the condenser side at a partial pressure that permits evaporation and condensation of the cooling medium during operation.

9. The electronic power module of claim 8, wherein the wick structure includes a primary wick structure disposed adjacent to the evaporator side and a secondary wick structure extending from the condenser side to the primary wick structure for wicking the cooling medium from the condenser to the primary wick structure.

10. The electronic power module of one of claims 1 to 9, comprising a heat dissipation structure thermally coupled to the phase change heat spreader for dissipating heat transferred to the phase change heat spreader.
